# EUROPÄISCHE PATENTANMELDUNG

(11) **EP 0 766 313 A1**
(43) Veröffentlichungstag der Anmeldung: **02.04.1997**
(21) Anmeldenummer: 96114963.0
(22) Anmeldetag: 18.09.1996
(51) Int. Cl.: H01L 27/108, H01L 21/8242

(54) **Stapelkondensator für DRAM-Bauteile**

(30) Priorität: 29.09.1995 DE 19536528
(71) Anmelder: SIEMENS AKTIENGESELLSCHAFT, 80333 München (DE)
(72) Erfinder: Müller, Karlheinz, Ing., 84478 Waldkraiburg (DE)

(57) **Zusammenfassung**

Bei einem integrierbaren Kondensator mit zwei Elektroden (E1,E2) weist wenigstens eine der Elektroden (E1,E2) mehr als eine elektrisch leitende Schicht (1,2,...) auf, wobei alternierende Schichten aus verschiedenen Materialien aufgebaut sind. Die Erfindung kann in einem dynamischen Halbleiterspeicher DRAM angewendet werden. Eine Kombination mit herkömmlichen Kondensatoren von "trench capacitor" oder "stacked capacitor" Typ ist möglich.

## Beschreibung

Die Erfindung betrifft einen integrierbaren Kondensator mit zwei Kondensatorelektroden sowie ein verfahren zum Herstellen eines solchen.

Gattungsgemäße integrierbare Kondensatoren sind allgemein als sogenannte Plattenkondensatoren bekannt. In integrierter Form, zum Beispiel als Speicherkondensatoren von Speicherzellen dynamischer Halbleiterspeicher (allgemein als "DRAM" bezeichnet) sind darüber hinaus noch Kondensatoren in der sogenannten Trenchform und in der Form als "Stacked Capacitor" bekannt. Auch bei diesen beiden Kondensatortypen handelt es sich im wesentlichen um Plattenkondensatoren mit zwei Kondensatorelektroden.

Bei all diesen integrierbaren Kondensatoren besteht die Forderung, daß sie bei Integration in einem Halbleiterchip sich elektrisch, mechanisch und chemisch möglichst gut mit den sonstigen Materialien, die der Halbleiterchip aufweist, vertragen. Von besonderer Wichtigkeit sind dabei Haftvermögen, Unterbindbarkeit von unerwünschten Diffusionsvorgängen und Abscheidbarkeit in Verbindung mit den sonstigen Materialien des Halbeiterchips, sowie ein geringer Platzbedarf.

Aus diesem Grund ist es wünschenswert, einen integrierten Kondensator zu schaffen, der die obengenannten Anforderungen weitgehend erfüllt. Darüber hinaus ist es auch wünschenswert, einen solchen Kondensator herstellen zu können.

Diese Aufgabe wird bei gattungsgemäßen Kondensatoren bzw. Verfahren gelöst durch die kennzeichnenden Merkmale der Patentansprüche 1 und 12. Vorteilhafte Aus- und Weiterbildungen sind in Unteransprüchen gekennzeichnet.

Nachstehend wird die Erfindung anhand der Zeichnung näher erläutert. Es zeigen:
- Die Figuren 1, 2:: erfindungsgemäße Kondensatoren im Querschnitt,
- Figur 3:: stark schematisiert eine vorteilhafte Verwendung in einem dynamischen Halbleiterspeicher,
- Figur 4:: mehrere Kondensatoren mit gemeinsamer anderer Elektrode,
- die Figuren 5 bis 7:: Stadien bei der Herstellung des Kondensators.

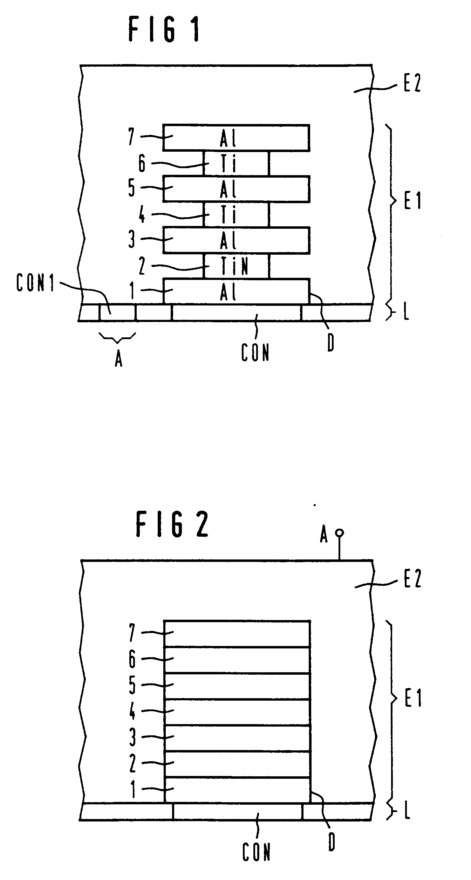

Figur 1 zeigt einen integrierbaren Kondensator mit zwei Kondensatorelektroden E1, E2, die, wie bei Kondensatoren allgemein üblich, mittels eines Dielektrikums D elektrisch voneinander getrennt sind. Der Kondensator ist auf einer Schicht L angeordnet, die Kontaktierungsmaterial CON enthält, welches einer elektrischen Verbindung des Kondensators mit anderen elektrischen oder elektronischen Elementen dient. Erfindungsgemäß ist nun vorgesehen, daß wenigstens die eine Elektrode E1 mehrere elektrisch leitende Schichten 1 bis 7 aufweist, wobei vorzugsweise aneinander angrenzende Schichten (z.B. die Schichten 1 und 2) aus verschiedenen Materialien aufgebaut sind. Bis auf den Verwendungszweck in einer integrierten Schaltung, d.h. einem Halbleiterchip, abgestimmter Auswahl der Materialien der Schichten 1 bis 7 lassen sich die eingangs genannten Forderungen leicht erfüllen, so daß sich der erfindungsgemäße Kondensator problemlos in einem Halbleiterchip integrierten läßt. In Weiterbildung der Erfindung weist der Kondensator noch folgende Besonderheit auf: die andere Elektrode E2 ist so ausgestaltet, daß das auf der Oberfläche der einen Elektrode E1 angeordnete Dielektrikum D, das im allgemeinen eine Oxidschicht ist oder eine Verbundschicht aus Oxid und anderen Stoffen wie z. B. Nitriden) vollständig von der anderen Elektrode E2 umschlossen ist, abgesehen von demjenigen Bereich der Oberfläche der einen Elektrode E1, der auf der Schicht L mit dem Kontaktierungsmaterial CON angeordnet ist. Die andere Elektrode E2, die ebenfalls aus mehr als einer elektrisch leitenden Schicht aufgebaut sein kann (nicht dargestellt), weist dabei einen Anschlußkontakt A auf, der irgendwo an der anderen Elektrode E2 angebracht sein kann. Er ist in Figur 1 (und auch in Figur 2) nur schematisch angedeutet. Er kann insbesondere auch, wie in Figur 1 dargestellt, in der Schicht L mittels eines weiteren Kontaktierungsmaterials CON1 angeordnet sein. Aufgrund dieser spezialen Anordnung der anderen Elektrode E2 weist der erfindungsgemäße Kondensator eine höhere spezifische Speicherkapazität auf gegenüber herkömmlichen Plattenkondensatoren und letztendlich gegenüber (integrierten) Kondensatoren vom Trench- und Stack-Typ. Dies basiert nun auf folgendem: Bei Kondensatoren ist die Speicherkapazität unter anderem abhängig von der Fläche F der Elektroden, soweit diese über das Dielektrikum elektrostatisch miteinander in Wirkung stehen. Wenn nun, wie bei herkömmlichen Plattenkondensatoren allgemein üblich, eine Elektrode zwei relativ große Grundflächenbereiche der Oberfläche und zwei relativ kleine Seitenflächenbereiche der Oberfläche aufweist, so ist lediglich einer der beiden Grundflächenbereiche beitragswirksam bezüglich der Kapazität des Kondensators.

Bei der vorliegenden Weiterbildung hingegen ist es so, daß zum einen die einzelnen Oberflächenbereiche nicht dieses krasse Mißverhältnis zueinander aufweisen wie die obengenannten Grund- und Seitenflächenbereiche. Zum anderen ist es aber auch so, daß vorliegend drei der vier Oberflächenbereiche der einen Elektrode E1 (zusammen mit entsprechenden Oberflächenbereichen der anderen Elektrode E2) ihren Beitrag zur Kapazität des Kondensators liefern, nämlich die drei Bereiche der einen Elektrode E1, die mittels des Dielektrikums D von der anderen Elektrode E2 getrennt sind.

Die mehreren Schichten 1 bis 7, die aus verschiedenen Materialien aufgebaut sind, können erfindungsgemäß aus Aluminium Al, Titan Ti, oder Titannitrid TiN aufgebaut sein. Weitere Titanverbindungen wie Titanwolfram TiW sowie Aluminiumverbindungen sind möglich. Über diese genannten Materialien hinaus sind auch andere elektrisch leitende Materialien verwendbar, soweit sie die vorgenannten Anforderungen an die Integrierbarkeit erfüllen.

Weiterhin zeigt Figur 1 eine geometrische Ausgestaltung der einzelnen elektrisch leitenden Schichten 1 bis 7 der einen Elektrode E1 dergestalt, daß aneinander angrenzende Schichten (z. B. die Schichten 2 und 3) voneinander verschiedene Querschnitte aufweisen. Diese Maßnahme vergrößert, im Vergleich zu der in Figur 2 dargestellten Ausführungsform, bei der diese Schichten 1 bis 7 alle gleich sind, die über das Dielektrikum D mit der anderen Elektrode E2 in kapazitiver Wirkung stehende Gesamtfläche nochmals, woraus gegenüber der Ausführungsform nach Figur 2 eine nochmals erhöhte Kapazität resultiert.

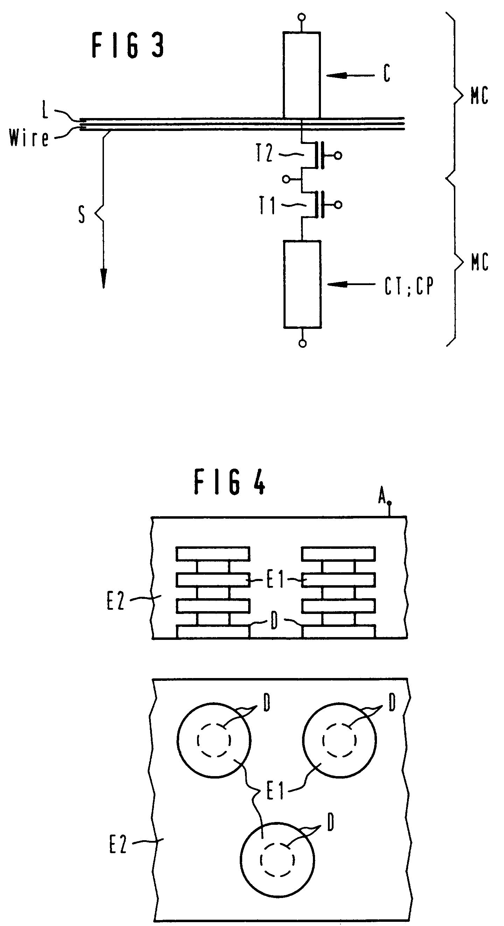

Der geschilderte integrierbare Kondensator ist demzufolge hervorragend dazu geeignet, bei vorgenommener Integration in eine integrierte Halbleiterschaltung beispielsweise als Speicherkondensator C von Speicherzellen MC eines dynamischen Halbleiterspeichers verwendet zu sein, wie in Figur 3 schematisch gezeigt. Dabei ist es auch möglich, zwei benachbarte Speicherzellen MC folgendermaßen auszugestalten (ebenfalls in Figur 3 stark schematisiert dargestellt) : Innerhalb des bei Halbleiterspeichern üblichen Substrates S oder auf diesem sind angeordnet: Ein Speicherkondensator von einem anderen Typ als den erfindungsgemäßen Kondensator, zum Beispiel ein Speicherkondensator CT vom Trenchtyp (angeordnet innerhalb des Substrates) oder ein Speicherkondensator CP vom Platten-typ (angeordet auf dem Substrat), ein erster Auswahltransistor T1, der zusammen mit dem Kondensator CT bzw. CP eine erste Speicherzelle MC bildet, und ein zweiter Auswahltransistor T2. Oberhalb des Substrates S ist die heutzutage übliche Mehrlagenverdrahtung Wire für Wortleitungen und Bitleitungen des Halbleiterspeichers angeordnet, ggf. ergänzt um weitere Ebenenen (z.B. für eine Ebene, mittels derer die anderen Elektroden E2 von bezüglich ihrer Anordnung noch zu beschreibenden Kondensatoren vom erfindungsgemäßen Typ anschließbar sind). Darüber wiederum sind die bereits beschriebene elektrisch isolierende Schicht L und ein Speicherkondensator C vom erfindungsgemäßen Typ, speziell in der Ausführungsform nach Figur 1, angeordnet. Dieser bildet nun zusammen mit dem zweiten Auswahltransistor T2 eine zweite Speicherzelle MC des dynamischen Halbleiterspeichers, welche in etwa oberhalb der ersten Speicherzelle angeordnet ist. Somit lassen sich unter Verwendung des erfindungsgemäßen Kondensators C in der gezeigten Ausführungsform nach Figur 1 auf einer Fläche eines Halbleitersubstrats, die wesentlich kleiner ist als die von zwei Speicherzellen mit bekannten Speicherkondensatoren beanspruchte Fläche, zwei Speicherzellen anordnen, wobei der Kondensator C der zweiten Speicherzelle MC ein Speicherkondensator vom Typ des erfindungsgemäßen Kondensators ist. Dabei kann die andere Elektrode E2 nach oben hin (wie in Figur 2 schematisch angedeutet) mit einer Potentialplatte verbunden sein oder aber auch durch die Schicht L hindurch nach unten hin (vgl. Figur 1 mit dem weiteren Kontaktierungsmaterial CON1).

Eine solche räumliche Anordnung zweier Speicherzellen übereinander ist bislang nicht möglich, weil beispielsweise bei einer Kombination von mittels eines Trenchkondensators gebildeter erster Speicherzelle mit einer mittels eines Stacked Capacitor gebildeten zweiten Speicherzelle die Mehrlagenverdrahtung insbesondere der Wortleitungen und Bitleitungen oberhalb des Stacked Capacitors erfolgen müßte (dies insbesondere dann, wenn, wie bei der vorliegenden Erfindung in einer Ausführungsform vorgesehen, mehrere Schichten 1... der einen Elektrode E1 vorhanden wären, da dann der räumliche Aufbau des Stacked Capacitors so hoch würde für eine Mehrlagenverdrahtung oberhalb desselben, daß die Chipoberfläche so zerklüftet würde (große Höhenunterschiede), daß eine sichere, qualitativ hochwertige Herstellung der Mehrlagenverdrahtung nicht mehr sichergestellt wäre.

Figur 4 zeigt die Verwendung mehrere erfindungsgemäßer Kondensatoren in der Ausführungsform nach Figur 1 im Querschnitt (zwei Kondensatoren) und in Draufsicht (drei Kondensatoren), die als die andere Elektrode E2 eine allen Kondensatoren gemeinsame Elektrode aufweisen.

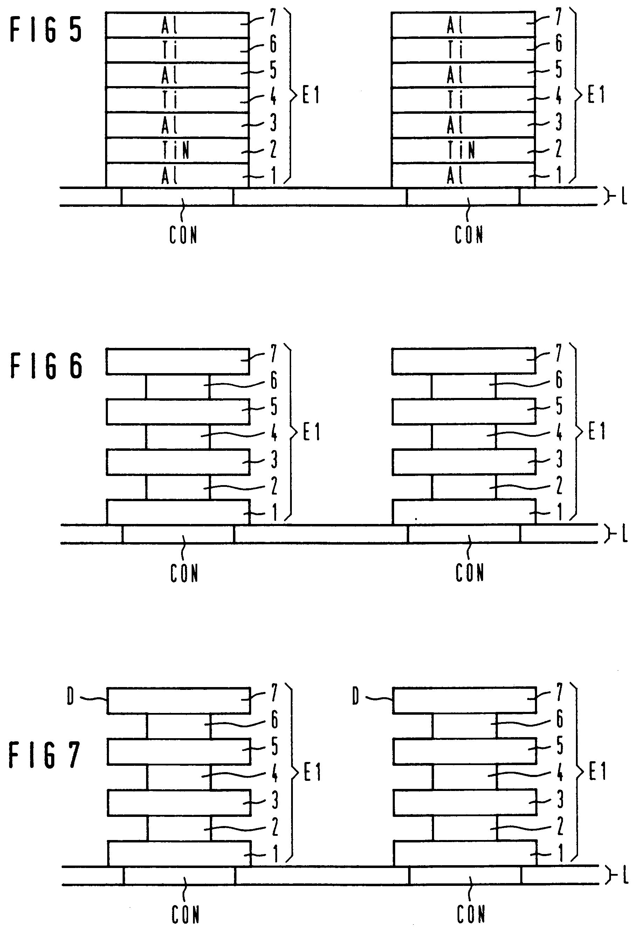

Der erfindungsgemäße Kondensator läßt sich nach folgendem Verfahren herstellen (vgl. unter anderem die Figuren 5 bis 7, die auch bereits vorteilhafte Weiterbildungen zeigen) : Auf eine Schicht L, die in einem Bereich Kontaktierungsmaterial CON aufweist (vgl. die Figuren 1, 5) wird oberhalb dieses Bereiches mehr als eine elektrisch leitende Schicht 1 als die eine Elektrode E1 aufgebracht (in Figur 5 sind insgesamt 7 Schichten 1 bis 7 dargestellt). Anschließend wird die eine Elektrode E1 wenigstens an einer ihrer Hauptflächen und maximal an allen ihren Hauptflächen, auf jeden Fall mit Ausnahme desjenigen Oberflächenbereiches, der an die Schicht L und das Kontaktierungsmaterial CON angrenzt (in Figur 5 z.B. alle sieben Schichten 1 bis 7 gemeinsam), mit einem Dielektrikum D bedeckt (siehe Figur 7), beispielsweise mit einem Oxid oder mit einer Oxid-Nitrid-Verbundschicht. Abschließend wird als andere Elektrode E2 wenigstens eine elektrisch leitende Schicht auf das Dielektrikum D aufgebracht. Dabei weist insgesamt wenigstens eine der beiden Elektroden E1, E2 mehr als eine elektrisch leitende Schicht 1 auf. Die weiteren elektrisch leitenden Schichten 2, 3 ... werden dabei vorzugsweise auf die jeweils vorhergehende, d.h. vorübergehend letzte elektrisch leitende Schicht 1, 2,...aufgebracht.

Vorteilhafterweise wird die andere Elektrode E2 so auf die Schicht L aufgebracht, daß sie (oberhalb der Schicht L) die eine Elektrode E1 samt Dielektrikum D vollständig umhüllt (siehe Figuren 1, 2, 4). Eine elektrische Kontaktierung der anderen Elektrode E2 mit einem elektrischen Potential oder einem Signal kann dann entweder direkt über einen Anschluß A erfolgen (vgl. Figur 2) oder über einen weiteren Bereich der Schicht L, der Weiteres Kontaktierungsmaterial CON1 enthält (siehe Figur 1). Beim Herstellen der einen Elektrode E1 in Form von mehreren leitenden Schichten 1 bis 7 (siehe Figuren 1, 2 sowie 5 bis 7), die ggf. auch unterschiedlich groß sein können (siehe Figur 1), werden in diesem Fall vor dem Umhüllen mit dem Dielektrikum D die einzelnen Schichten 1 bis 7 entsprechend ihrer gewünschten Größe strukturiert (vgl. Figur 6). Diese Strukturierung kann entweder für jede einzelne Schicht erfolgen nach ihrem jeweiligen Aufbringen oder aber (zum Beispiel durch selektives Ätzen) erst dann, wenn mehrere oder alle gewünschten Schichten 1 bis 7 aufgebracht sind (dieses ist bei den Figuren 5, 6 angenommen).

## Patentansprüche

1. Integrierbarer Kondensator mit zwei Kondensatorelektroden (E1, E2),
**dadurch gekennzeichnet**, daß wenigstens die eine Elektrode (E1) aus wenigstens zwei elektrisch leitenden Schichten (1, 2, 3,...) aufgebaut ist,
daß aneinander angrenzende elektrisch leitende Schichten (1, 2, 3,...) aus verschiedenen Materialien aufgebaut sind, und daß die aneinander angrenzenden elektrisch leitende Schichten (1 bis 7), im Querschnitt zur jeweiligen Schicht (1 bis 7) betrachtet, verschieden breit sind.

2. Integrierbarer Kondensator nach Anspruch 1,
**dadurch gekennzeichnet**, daß wenigstens eines der Materialien Aluminium (Al) oder eine elektrisch leitende Aluminiumverbindung ist.

3. Integrierbarer Kondensator nach Anspruch 1 oder 2,
**dadurch gekennzeichnet**, daß wenigstens eines der Materialien Titan (Ti) oder eine elektrisch leitende Titanverbindung (TiW, TiN) ist.

4. Integrierbarer Kondensator nach einem der vorhergehenden Ansprüche,
**dadurch gekennzeichnet**, daß die eine Elektrode (E1) abgesehen von einem Oberflächenanteil, der einer Kontaktierung der einen Elektrode (E1) dient, in der anderen Elektrode (E2) eingebettet ist.

5. Integrierbarer Kondensator nach einem der vorhergehenden Ansprüche,
**dadurch gekennzeichnet**, daß er als Speicherkondensator (C) in Speicherzellen (MC) eines integrierten dynamischen Halbleiterspeichers verwendet ist.

6. Integrierbarer Kondensator nach Anspruch 5,
**dadurch gekennzeichnet**, daß der Speicherkondensator (C) bei einer von zwei einander benachbarten Speicherzellen (MC) des integrierten dynamischen Halbleiterspeichers verwendet ist und daß die andere der beiden benachbarten Speicherzellen (MC) einen Speicherkondensator (CT, CP) einer anderen Bauart aufweist.

7. Integrierbarer Kondensator nach Anspruch 6,
**dadurch gekennzeichnet**, daß die andere Bauart vom Plattentyp (CP) oder vom Trenchtyp (CT) ist.

8. Integrierbarer Kondensator nach einem der vorhergehenden Ansprüche,
**dadurch gekennzeichnet**, daß seine andere Elektrode (E2) weiteren integrierbaren Kondensatoren, die gemäß einem der vorhergehenden Ansprüche gestaltet sind, jeweils als andere Elektrode (E2) dient, so daß diese mehreren integrierbaren Kondensatoren eine einzige gemeinsame Elektrode als andere Elektrode (E2) aufweisen.

9. Verfahren zum Herstellen eines integrierbaren Kondensators mit zwei Kondensatorelektroden (E1, E2) nach Anspruch 1,
**dadurch gekennzeichnet**, daß
- zur Herstellung der einen Elektrode (E1) auf eine ein Kontaktierungsmaterial (CON) enthaltende Schicht (L) wenigstens eine elektrisch leitende Schicht (1, 2, 3,...) aufgebracht wird,
- daß die eine Elektrode (E1) wenigstens an einer ihrer Hauptflächen und maximal an allen ihren Hauptflächen mit Ausnahme desjenigen Bereiches, der an die das Kontaktierungsmaterial (CON) enthaltende Schicht (L) und das Kontaktierungsmaterial (CON) angrenzt, mit einem Dielektrikum (D) bedeckt wird,
- daß als andere Elektrode (E2) wenigstens eine elektrisch leitende Schicht auf das Dielektrikum aufgebracht wird,
- daR die beiden Elektroden (E1, E2) so hergestellt werden, daß wenigstens eine der beiden Elektroden (E1, E2) mindestens zwei elektrisch leitende Schichten (1,2...) aus verschiedenen Materialien aufweist, und daß aneinandergrenzende Schichten (1 bis 7), im Querschnitt zur jeweiligen Schicht betrachtet, verschieden breit sind.

10. Verfahren nach Anspruch 9,
**dadurch gekennzeichnet**, daß bei der Herstellung einer jeweiligen weiteren elektrisch leitenden Schicht (2, 3,...) diese oberhalb der jeweiligen letzten elektrisch leitenden Schicht (1, 2, 3,...) aufgebracht wird.

11. Verfahren nach einem der Ansprüche 9 oder 10,
**dadurch gekennzeichnet**, daß die andere Elektrode (E2) so auf die das Kontaktierungsmaterial (CON) enthaltende Schicht (L) aufgebracht wird, daß sie die eine Elektrode (E1) samt Dielektrikum (D) oberhalb der Schicht (L) vollständig umhüllt.
